# EUROPEAN PATENT SPECIFICATION

(11) **EP 4 685 551 B1**
(45) Date of publication and mention of the grant of the patent: **30.09.2026**
(21) Application number: 25173946.2
(22) Date of filing: 02.05.2025
(51) Int. Cl.: G02F 1/1333, G02F 1/1339

(54) **DISPLAY DEVICE AND ELECTRONIC DEVICE INCLUDING THE SAME**
ANZEIGEVORRICHTUNG UND ELEKTRONISCHE VORRICHTUNG DAMIT
DISPOSITIF D'AFFICHAGE ET DISPOSITIF ÉLECTRONIQUE LE COMPRENANT

(30) Priority: 25.07.2024 KR 20240098708
(43) Date of publication of application: 28.01.2026
(73) Proprietor: Samsung Display Co., Ltd., Yongin-si, Gyeonggi-do 17113 (KR)
(72) Inventor: NAMKUNG, Jun, Yongin-si (KR)
(74) Representative: Marks & Clerk LLP

(56) References cited:
- US-A1- 2015 068 674
- US-A1- 2015 355 498
- US-A1- 2018 348 568
- US-A1- 2019 051 858
- US-A1- 2021 333 618

## Description

### BACKGROUND

### 1. Field

Aspects of some embodiments of the present disclosure relate to a display device and an electronic device including the same.

### 2. Description of the Related Art

As the information society develops, consumer demand for display devices for displaying images has increased and diversified. Display devices include, for example, flat panel display devices such as liquid crystal displays (LCDs), field emission displays (FEDs), or light emitting displays (LEDs). A light emitting display device may include an organic light emitting display device including organic light emitting diode elements as light emitting elements or a light emitting diode display device including inorganic light emitting diode elements such as light emitting diodes (LEDs) as light emitting elements.

In the display device, light emitted from a display panel may leak to edge portions (e.g., side surfaces) other than a display surface that may be visible to a user. In order to cope with the leakage of the light to the edge portions, research into technology that blocks light of the edge portions of the display device has been actively conducted.

The above information disclosed in this Background section is only for enhancement of understanding of the background and therefore the information discussed in this Background section does not necessarily constitute prior art.

US 2019/051858 A1 discloses a display device comprising: a display panel; an optical layer on the display panel and including at least one polarizer layer; a cover window on the optical layer; and a light blocking member between the cover window and the display panel and on a side surface of the optical layer, wherein the light blocking member includes a first region, and the first region is in contact with the optical layer.

### SUMMARY

Aspects of some embodiments of the present disclosure include a display device capable of preventing or reducing damage to the display device due to stress.

However, aspects of embodiments according to the present disclosure are not restricted to those set forth herein. The above and other aspects of embodiments according to the present disclosure will become more apparent to one of ordinary skill in the art to which the present disclosure pertains by referencing the detailed description of the present disclosure given below.

According to the claimed embodiments of the present invention, a display device comprises a display panel, an anti-reflection layer on the display panel and including at least one polarizer layer, a cover window on the anti-reflection layer, and a light blocking member between the cover window and the display panel and on a side surface of the anti-reflection layer, wherein the light blocking member includes a first region and a second region having different curing rates, and at least one of the first region or the second region is in contact with the anti-reflection layer.

According to some embodiments, the first region may cover the second region and may be at an outer side of the light blocking member, and the second region may be at an inner side of the light blocking member.

According to some embodiments, the first region may be in contact with each of a lower surface of the cover window and an upper surface of the display panel, and the second region is not in contact with the lower surface of the cover window.

According to some embodiments, a curing rate of the first region may be higher than that of the second region.

According to some embodiments, a curing rate of the first region may be 85% to 100%.

According to some embodiments, a curing rate of the second region may be 25% to 55%.

According to some embodiments, the light blocking member may further include a third region between the first region and the second region, and a curing rate of the third region may be lower than a curing rate of the first region and higher than a curing rate of the second region.

According to some embodiments, a curing rate of the third region may be higher than 55% and lower than 85%.

According to some embodiments, the anti-reflection layer may include a first bonding member on the display panel, a first phase retardation layer on the first bonding member, a second bonding member on the first phase retardation layer, a second phase retardation layer on the second bonding member, a support layer on the second phase retardation layer, and a hard coating layer on the polarizer layer, and the polarizer layer may be between the support layer and the hard coating layer.

According to some embodiments, the second region may be in contact with an upper surface and a side surface of the second phase retardation layer.

According to some embodiments of the present disclosure, a display device comprises a display panel, an anti-reflection layer on the display panel and including at least one polarizer layer and phase retardation layers, a cover window on the anti-reflection layer, and a light blocking member between the cover window and the display panel and on a side surface of the anti-reflection layer, wherein the light blocking member includes a first region and a second region having a curing rate lower than a curing rate of the first region, and the second region is in contact with any one of the phase retardation layers.

According to some embodiments, the first region may cover the second region and may be at an outer side of the light blocking member, and the second region may be at an inner side of the light blocking member.

According to some embodiments, the curing rate of the first region may be higher than 70% and lower than or equal to 100%.

According to some embodiments, the curing rate of the second region may be 25% to 70%.

According to some embodiments, a modulus of the second region may be smaller than a modulus of the first region.

According to some embodiments of the present disclosure, an electronic device comprises, a display device comprising a display panel, an anti-reflection layer on the display panel and including at least one polarizer layer, a cover window on the anti-reflection layer, and a light blocking member between the cover window and the display panel and on a side surface of the anti-reflection layer, wherein the light blocking member includes a first region and a second region having different curing rates, and at least one of the first region or the second region is in contact with the anti-reflection layer.

According to some embodiments, the curing rate of each of the first region and the second region may decrease from an outer side of the light blocking member toward an inner side of the light blocking member.

According to some embodiments, a curing rate decrease gradient of the second region may be greater than a curing rate decrease gradient of the first region.

According to some embodiments, the light blocking member may further include a third region between the first region and the second region, and a curing rate of the third region may decrease from the outer side of the light blocking member toward the inner side of the light blocking member.

According to some embodiments, a curing rate decrease gradient of the third region may be greater than the curing rate decrease gradient of the first region and the curing rate decrease gradient of the second region.

At least some of the above and other features of the invention are set out in the claims.

A display device according to some embodiments may prevent or reduce instances of a crack occurring in an anti-reflection layer when the anti-reflection layer shrinks by making a curing rate of an inner side of a light blocking member in contact with the anti-reflection layer lower than that of an outer side of the light blocking member.

The characteristics of embodiments according to the present disclosure are not limited to the aforementioned characteristics, and various other characteristics are included in the present specification.

### BRIEF DESCRIPTION OF THE DRAWINGS

The above and other aspects and features of embodiments according to the present disclosure will become more apparent by describing in more detail aspects of some embodiments thereof with reference to the attached drawings, in which:
FIG. 1 is a schematic perspective view of an electronic device according to some embodiments;
FIG. 2 is a schematic perspective view of a display device according to some embodiments;
FIG. 3 is a schematic cross-sectional view taken along the line X1-X1' of FIG. 2;
FIG. 4 is a schematic cross-sectional view illustrating an illustrative stacked structure of a display module according to some embodiments;
FIG. 5 is a schematic cross-sectional view illustrating the display device according to some embodiments;
FIG. 6 is an enlarged view of region A of FIG. 5;
FIG. 7 is a graph illustrating a curing rate of a light blocking member;
FIG. 8 is a schematic cross-sectional view illustrating a portion of a display device according to some embodiments;
FIG. 9 is a graph illustrating a curing rate of a light blocking member;
FIGS. 10 to 13 are cross-sectional views illustrating processes of a method of manufacturing the display device according to some embodiments; and
FIG. 14 is an image of an uncured light blocking member.

### DETAILED DESCRIPTION

Aspects of some embodiments of the present disclosure will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, aspects of some embodiments according to the present disclosure will be described in more detail with reference to the accompanying drawings.

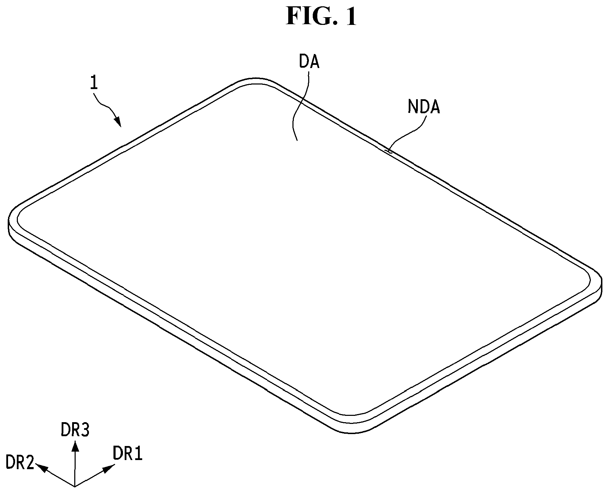

FIG. 1 is a schematic perspective view of an electronic device according to some embodiments.

Referring to FIG. 1, an electronic device 1 according to some embodiments displays a moving image or a still image. The electronic device 1 may refer to all electronic devices that provide display screens. For example, televisions, laptop computers, monitors, billboards, the Internet of Things (IoT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the display device 10.

The electronic device 1 may include a display device providing a display screen. Examples of the display device may include an inorganic light emitting diode display device, an organic light emitting display device, a quantum dot light emitting display device, a plasma display device, a field emission display device, and the like. Hereinafter, a case where an organic light emitting diode display device is applied as an example of the display device will be described by way of example, but embodiments according to the present disclosure are not limited thereto, and the same technical idea may be applied to other display devices if applicable.

A shape of the electronic device 1 may be variously modified. For example, the electronic device 1 may have a shape such as a rectangular shape with a width greater than a length, a rectangular shape with a length greater than a width, a square shape, a quadrangular shape with rounded corners (vertices), other polygonal shapes, or a circular shape. A shape of a display area DA of the electronic device 1 may also be similar to an overall shape of the electronic device 1. In FIG. 1, the electronic device 1 having a rectangular shape with a great length in a second direction DR2 has been illustrated.

The electronic device 1 may include a display area DA and a non-display area NDA. The display area DA is an area where a screen may be displayed, and the non-display area NDA is an area where the screen is not displayed. The display area DA may also be referred to as an active area, and the non-display area NDA may also be referred to as a non-active area. The display area DA may occupy the center (or substantially the center) of the electronic device 1.

The non-display area NDA may be arranged around (e.g., in a periphery or outside a footprint of) the display area DA. The non-display area NDA may be a bezel area. The non-display area NDA may surround the display area DA. However, embodiments according to the present disclosure are not limited thereto, and for example, the non-display area NDA may not be located in at least a portion of a peripheral area of the display area DA. Signal lines or driving circuits for applying signals to the display area DA (display area or touch area) may be located in the non-display area NDA. According to some embodiments, the non-display area NDA may include a portion of the touch area, and a sensor member such as a pressure sensor may be located in the corresponding area.

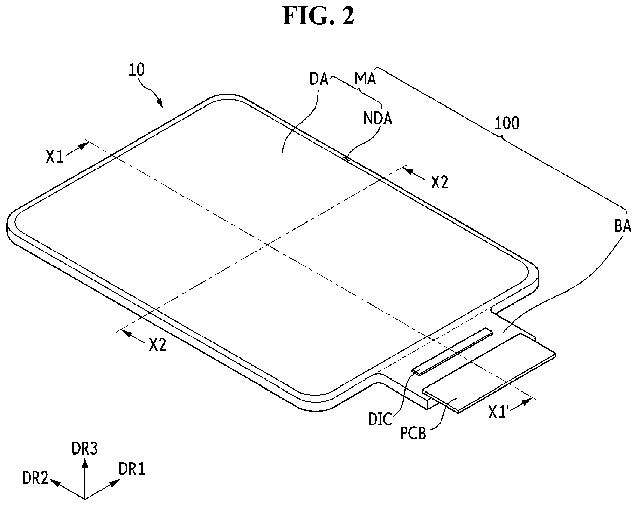

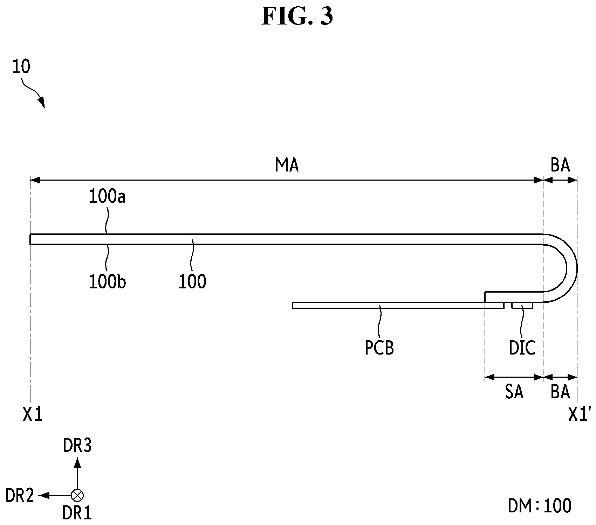

FIG. 2 is a schematic perspective view of a display device according to some embodiments. FIG. 3 is a schematic cross-sectional view taken along the line X1-X1' of FIG. 2.

Referring to FIGS. 2 and 3, the electronic device 1 according to some embodiments may include a display device 10. The display device 10 may provide a screen displayed on the electronic device 1. The display device 10 may have a shape similar to that of the electronic device 1 in a plan view. For example, the display device 10 may have a shape similar to a rectangular shape having short sides in a first direction DR1 and long sides in the second direction DR2. A corner where the short side in the first direction DR1 and the long side in the second direction DR2 meet may be rounded with a curvature, but embodiments according to the present disclosure are not limited thereto, and may also be right-angled. The shape of the display device 10 in a plan view is not limited to the rectangular shape, and may be a shape similar to other polygonal shapes, irregular shapes, a circular shape, or an elliptical shape.

The display device 10 may include a display panel 100, a driving chip DIC, and a driving board PCB.

The display panel 100 may include a main area MA, a sub-area SA, and a bending area BA. The bending area BA may be located between the main area MA and the sub-area SA in the second direction DR2. The main area MA may be located on one side of the bending area BA in the second direction DR2. The sub-area SA may be located on the other side of the bending area BA in the second direction DR2.

The main area MA may include a display area DA including pixels displaying an image and a non-display area NDA arranged around the display area DA. The display area DA may emit light from a plurality of emission areas or a plurality of opening areas. For example, the display panel 100 may include pixel circuits including switching elements, a pixel defining film defining the emission areas or the opening areas, and self-light emitting elements.

For example, the self-light emitting element may include at least one of an organic light emitting diode (LED) including an organic light emitting layer, a quantum dot LED including a quantum dot light emitting layer, an inorganic LED including an inorganic semiconductor, or a micro LED, but embodiments according to the present disclosure are not limited thereto.

The main area MA may have a shape similar (or substantially similar) to a shape of the display panel 100 in a plan view. The main area MA may be a flat area positioned on one plane. However, embodiments according to the present disclosure are not limited thereto, and at least some of the edges of the main area MA may be curved in a third direction DR3 to form curved surfaces or may be bent in a vertical direction.

When at least some of the edges of the main area MA are curved in the third direction DR3 to form the curved surfaces or are bent in the vertical direction, the display area DA may also be located on the corresponding edges. However, embodiments according to the present disclosure are not limited thereto, and the curved surfaces or the bent edges may be the non-display area that does not display the screen or the display area and the non-display area may coexist in the curved surfaces or the bent edges.

The bending area BA may be connected to the other side of the main area MA in the second direction DR2. For example, the bending area BA may be connected to a short side of the lower side of the main area MA. A width of the bending area BA, for example, a width of the bending area BA in the first direction DR1, may be smaller than a width of the main area MA adjacent to the bending area BA, for example, a width of the main area MA in the first direction DR1. A connection portion between the main area MA and the bending area BA may have an L-cut shape.

The bending area BA may be an area where the display panel 100 is bent. In the bending area BA, the display panel 100 may be bent with a curvature in a downward direction in a thickness direction. For example, in the bending area BA, the display panel 100 may be bent toward the other side in the third direction DR3.

The bending area BA may have a constant radius of curvature, but is not limited thereto and may also have different radii of curvature for each section. The display panel 100 is bent in the bending area BA, and accordingly, a surface of the display panel 100 may be inverted. For example, the display panel 100 may be bent in a direction opposite to a first surface 100a, which is a display surface. Accordingly, a second surface 100b of the main area MA and a second surface 100b of the sub-area SA in a second surface 100b, which is a surface opposite to the display surface, may face each other in the third direction DR3.

The sub-area SA may be located on the other side of the bending area BA in the second direction DR2. The sub-area SA may extend from the bending area BA. A width of the sub-area SA, for example, a width of the sub-area SA in the first direction DR1, may be greater than the width of the bending area BA, for example, the width of the bending area BA in the first direction DR1. A connection portion between the sub-area SA and the bending area BA may have an L-cut shape.

According to some embodiments, a size of the sub-area SA may be smaller than a size of the main area MA of the display panel 100. For example, as illustrated in FIG. 3, in a state in which the display panel 100 is bent, the sub-area SA may completely overlap the main area MA. In the state in which the display panel 100 is bent, an outer edge of the sub-area SA may be surrounded by an outer edge of the main area MA in a plan view. The outer edge of the sub-area SA may be located inside the outer edge of the main area MA in a plan view.

As illustrated in FIG. 3, in the state in which the display panel 100 is bent, the sub-area SA may overlap the main area MA in the thickness direction of the display panel 100, that is, the third direction DR3. The sub-area SA may be located below the main area MA in the third direction DR3.

The driving chip DIC may be located on the sub-area SA of the display panel 100. According to some embodiments, the driving chip DIC may be located on the first surface 100a of the display panel 100 in the sub-area SA of the display panel 100. According to some embodiments, the driving chip DIC may be directly mounted on the display panel 100 in a chip on glass (COG) or chip on plastic (COP) manner, as illustrated in FIGS. 2 and 3. According to some embodiments, the driving chip DIC may be mounted on a flexible film in a chip on film (COF) manner.

The driving chip DIC may generate and output data voltages, source voltages, scan timing signals, and the like. The driving chip DIC may include an integrated circuit driving the display panel 100. The integrated circuit may include an integrated circuit for a display and/or an integrated circuit for a touch unit. However, embodiments according to the present disclosure are not limited thereto, and the integrated circuit for a display and the integrated circuit for a touch unit may be provided as separate chips or provided in a form in which they are integrated into one chip.

The driving board PCB may be located on one end of the sub-area SA of the display panel 100. A pad unit may be located on one end of the sub-area SA of the display panel 100. The pad unit may include a plurality of display signal line pads and touch signal line pads. The driving board PCB may be connected to the pad unit of one end of the sub-area SA of the display panel 100. The driving board PCB may be attached onto the pad unit using a conductive adhesive member such as an anisotropic conductive film and an anisotropic conductive adhesive. The driving board PCB may be a flexible printed circuit board or a flexible film such as a chip on film.

In the state in which the display panel 100 is bent, the driving chip DIC and the driving board PCB may be positioned on a side opposite to the display panel 100 of the main area MA with the display panel 100 of the sub-area SA interposed therebetween. That is, the driving chip DIC and the driving board PCB may be positioned on the first surface 100a of the sub-area SA and be positioned on a side distant from the main area MA in the third direction DR3 as the display panel 100 is bent.

According to some embodiments, a size of the driving board PCB may be smaller than the size of the main area MA of the display panel 100. For example, as illustrated in FIG. 3, in the state in which the display panel 100 is bent, the driving board PCB may completely overlap the main area MA of the display panel 100. In the state in which the display panel 100 is bent, an outer edge of the driving board PCB may be surrounded by the outer edge of the main area MA of the display panel 100 in a plan view. The outer edge of the driving board PCB may be located inside the outer edge of the main area MA of the display panel 100 in a plan view.

However, embodiments according to the present disclosure are not limited thereto, and according to some embodiments, a portion of the outer edge of the driving board PCB may coincide with a portion of the outer edge of the display panel 100 or may be located outside the outer edge of the display panel 100. In this case, a radius of an arc of the driving board PCB may be the same as or greater than a radius of an arc of the display panel 100.

A shape of the driving board PCB in a plan view may be similar or the same (or approximately similar) to the shape of the display panel 100 in a plan view. For example, when the display panel 100 has a circular shape in a plan view, at least a portion of the driving board PCB may have a circular shape. However, embodiments according to the present disclosure are not limited thereto, and a shape of the driving board PCB may be variously modified.

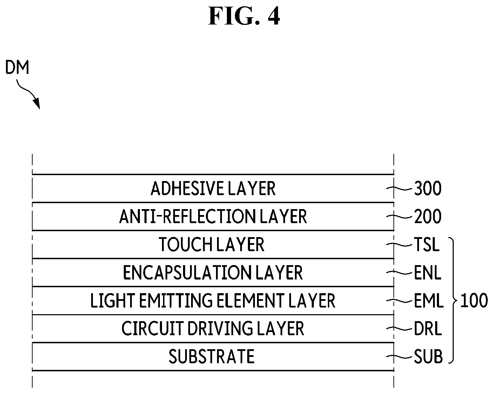

FIG. 4 is a schematic cross-sectional view illustrating an illustrative stacked structure of a display module according to some embodiments. Although FIG. 4 illustrates various layers or components in a display module according to some embodiments, embodiments according to the present disclosure are not limited thereto, and according to various embodiments, the display module may include additional layers or components, or fewer layers or components, or the stacking order of the layers or components may vary, unless otherwise stated or implied, without departing from the spirit and scope of embodiments according to the present disclosure.

Referring to FIG. 4, the display module DM may include a display panel 100, an anti-reflection layer 200, and an adhesive layer 300. The display panel 100 may include a substrate SUB, a circuit driving layer DRL, a light emitting element layer EML, an encapsulation layer ENL, and a touch layer TSL.

The substrate SUB may support components located thereon. The substrate SUB may include a transparent material. For example, the substrate SUB may include a transparent insulating material such as glass or quartz. The substrate SUB may be a rigid substrate. However, the substrate SUB is not limited thereto, and may include plastic such as polyimide, and may have flexible characteristics so as to be bent, folded, or rolled without damaging the display module DM.

The circuit driving layer DRL may be located on a first surface, for example, an upper surface, of the substrate SUB. The circuit driving layer DRL may include a circuit driving the light emitting element layer EML of a pixel. The circuit driving layer DRL may include a plurality of thin film transistors.

The light emitting element layer EML may be located on the circuit driving layer DRL. The light emitting element layer EML may include an organic light emitting layer. The light emitting element layer EML may emit light with various luminances depending on a driving signal transferred from the circuit driving layer DRL.

The encapsulation layer ENL may be located on the light emitting element layer EML. The encapsulation layer ENL may include an inorganic film or a stacked film of an inorganic film and an organic film. As another example, the encapsulation layer ENL may include glass, an encapsulation film, or the like.

The touch layer TSL may be located on the encapsulation layer ENL. The touch layer TSL is a layer sensing a touch input, and may function as the touch member. The touch layer TSL may include a plurality of sensing areas and sensing electrodes.

The anti-reflection layer 200 may be located on the display panel 100. The anti-reflection layer 200 may serve to reduce external light reflection. The anti-reflection layer 200 may be attached in the form of a polarizing film. In this case, the anti-reflection layer 200 may polarize light passing therethrough. However, embodiments according to the present disclosure are not limited thereto, and the anti-reflection layer 200 may be stacked in the form of a color filter layer. In this case, the anti-reflection layer 200 may include a color filter selectively transmitting light of a specific wavelength therethrough, or the like.

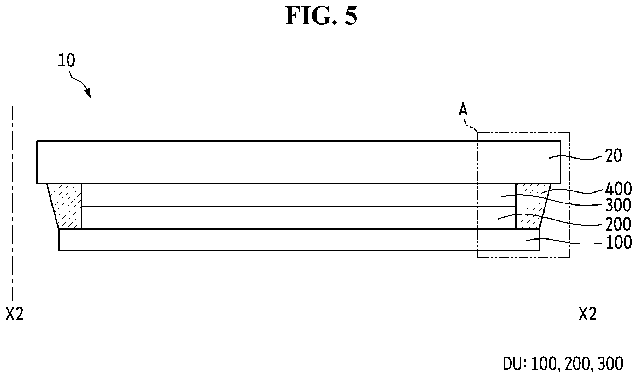

The adhesive layer 300 may be located on the anti-reflection layer 200. The adhesive layer 300 may adhere a cover window 20 (see FIG. 5) to the display panel 100 or the anti-reflection layer 200. In some embodiments, the adhesive layer 300 may be an optically clear adhesive (OCA) film or a pressure sensitive adhesive (PSA) film. However, the adhesive layer 300 may not be included in the display device 10, and the adhesive layer 300 may also be attached to the cover window and provided together with the cover window.

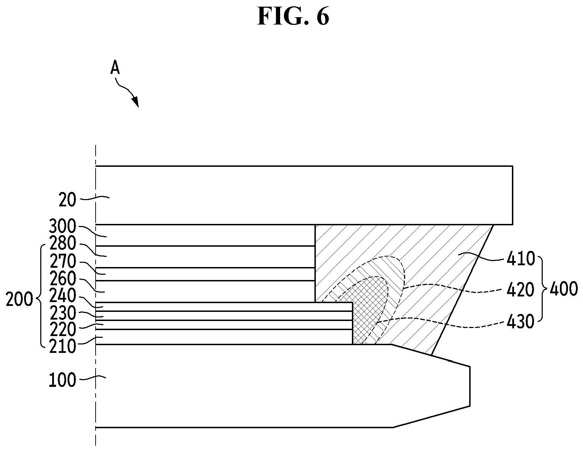

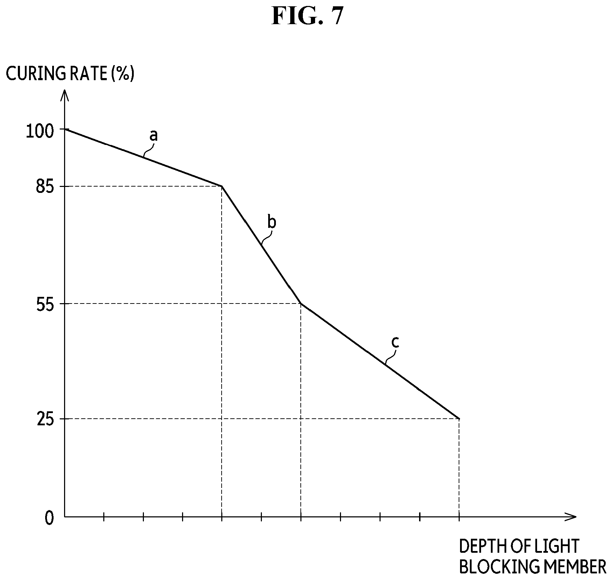

FIG. 5 is a schematic cross-sectional view illustrating the display device according to some embodiments. FIG. 6 is an enlarged view of region A of FIG. 5. FIG. 7 is a graph illustrating a curing rate of a light blocking member. For example, FIG. 5 illustrates a cross section taken along the line X2-X2' of FIG. 2.

Referring to FIGS. 5 to 7, the display device 10 according to some embodiments may include the display module DM, the cover window 20, and a light blocking member 400.

The display device 10 may further include the driving chip DIC and the driving board PCB, as described with reference to FIGS. 2 and 3. The display device 10 may include the display panel 100, the anti-reflection layer 200, and the adhesive layer 300, as described with reference to FIG. 4. Components of the display device 10 have been described above, and a detailed description thereof is thus omitted.

The cover window 20 may be attached to the display device 10 through the adhesive layer 300 of the display module DM. A size of the cover window 20 may be greater than a size of the display device 10. Accordingly, the cover window 20 may protrude outwardly from the display module DM.

The anti-reflection layer 200 may include first and second bonding members 210 and 230, first and second phase retardation layers 220 and 240, a support layer 260, a polarizer layer 270, and a hard coating layer 280. The anti-reflection layer 200 may have a structure in which the first bonding member 210, the first phase retardation layer 220, the second bonding member 230, the second phase retardation layer 240, the support layer 260, the polarizer layer 270, and the hard coating layer 280 are sequentially stacked.

The first bonding member 210 may be located directly on the display panel 100 and may bond the anti-reflection layer 200 to one surface of the display panel 100. The first bonding member 210 may be an adhesive layer or a pressure sensitive adhesive layer. For example, the first bonding member 210 may include a pressure sensitive adhesive (PSA).

The first phase retardation layer 220 may be located on the first bonding member 210. The first phase retardation layer 220 may be an optical layer retarding a phase of light. For example, the first phase retardation layer 220 may be a λ/4 phase retardation layer. For example, light transmitted through the polarizer layer 270 and provided to the first phase retardation layer 220 may be changed from a linearly polarized state to a circularly polarized state. In addition, light provided to the first phase retardation layer 220 in a circularly polarized state may be changed to a linearly polarized state.

The second bonding member 230 may be located on the first phase retardation layer 220, and may bond the first phase retardation layer 220 and the second phase retardation layer 240 to each other. The second bonding member 230 may be an adhesive layer or a pressure sensitive adhesive layer. For example, the second bonding member 230 may include a pressure sensitive adhesive (PSA).

The second phase retardation layer 240 may be located on the second bonding member 230. The second phase retardation layer 240 may be an optical layer retarding a phase of light. For example, the second phase retardation layer 240 may be a λ/2 phase retardation layer. The second phase retardation layer 240 may retard a phase of provided light by λ/2. For example, the second phase retardation layer 240 may change a wavelength of light transmitted through the polarizer layer 270 and provided to the second phase retardation layer 240 to λ/2. In addition, the second phase retardation layer 240 may change a polarized state of incident light. For example, the second phase retardation layer 240 may change a polarization direction of linearly polarized light incident from the polarizer layer 270 to the second phase retardation layer 240.

According to some embodiments, any one of a phase retardation value of the first phase retardation layer 220 in the thickness direction and a phase retardation value of the second phase retardation layer 240 in the thickness direction may have a positive value, and the other of the phase retardation value of the first phase retardation layer 220 in the thickness direction and the phase retardation value of the second phase retardation layer 240 in the thickness direction may have a negative value. For example, the first phase retardation layer 220 may be a positive A-plate, and the second phase retardation layer 240 may be a negative A-plate.

The support layer 260 may be located on the second phase retardation layer 240. The support layer 260 may be located directly beneath the polarizer layer 270 to support and protect the polarizer layer 270. The support layer 260 may include, for example, triacetyl cellulose (TAC).

The polarizer layer 270 may be located on the support layer 260. The polarizer layer 270 is an optical layer linearly polarizing the provided light in one direction, and may be a linear polarizer. The polarizer layer 270 may be a film-type linear polarizer including a stretched polymer film. For example, the stretched polymer film may be a stretched polyvinylalcohol-based film. The polarizer layer 270 may be manufactured by adsorbing a dichroic dye onto the stretched polymer film. For example, the polarizer layer 270 may be manufactured by adsorbing iodine onto a stretched polyvinylalcohol film. In this case, a direction in which the polymer film is stretched may be an absorption axis of the polarizer layer 270, and a direction perpendicular to the direction in which the polymer film is stretched may be a transmission axis of the polarizer layer 270.

The hard coating layer 280 may be located on the polarizer layer 270. The hard coating layer 280 may be located directly on the polarizer layer 270 to protect the polarizer layer 270. The hard coating layer 280 may include a resin such as an acrylic resin, a silicone resin, or a urethane resin.

The above-described anti-reflection layer 200 may be cut from a mother state to a size corresponding to the display panel 100 in order to be attached to the display panel 100. The cutting of the anti-reflection layer 200 in the mother state may be half-cutting. The half-cutting is a method in which the anti-reflection layer 200 is not completely cut, but is cut to a portion (e.g., a set or predetermined portion) in the thickness direction and then physically separated. For example, the support layer 260, the polarizer layer 270, and the hard coating layer 280 of the anti-reflection layer 200 may be cut by a laser beam, and the first and second bonding members 210 and 230 and the first and second phase retardation layers 220 and 240 of the anti-reflection layer 200 located below the support layer 260 may be physically separated. Accordingly, as illustrated in FIG. 6, respective side surfaces of the support layer 260, the polarizer layer 270, and the hard coating layer 280 of the anti-reflection layer 200 may be aligned and coincide with each other, and may be located inside respective side surfaces of the first and second bonding members 210 and 230 and respective side surfaces of the first and second phase retardation layers 220 and 240.

Meanwhile, the light blocking member 400 may be located between the cover window 20 and the display panel 100. The light blocking member 400 may prevent or reduce light leakage in which light leaks from a space between the display panel 100 and the cover window 20 to a side surface. The light blocking member 400 may be arranged to surround the display device 10 in a plan view. For example, the light blocking member 400 may surround at least three side surfaces of the display device 10, and may surround three side surfaces of the display device 10 except for a side surface of the display device 10 where the driving chip DIC is located in FIG. 2.

The light blocking member 400 may be in direct contact with a lower surface of the cover window 20 and an upper surface of the display panel 100 to be in contact with the cover window 20 and the display panel 100. According to some embodiments, the light blocking member 400 may partially cover the side surface of the display panel 100. The light blocking member 400 may be in contact with each of side surfaces of the anti-reflection layer 200 and the adhesive layer 300 located between the display panel 100 and the cover window 20. For example, the light blocking member 400 may be in contact with each of the side surface of the adhesive layer 300 and the side surfaces of the first and second bonding members 210 and 230, the first and second phase retardation layers 220 and 240, the support layer 260, the polarizer layer 270, and the hard coating layer 280 of the anti-reflection layer 200. According to some embodiments, the light blocking member 400 may cover a portion of an upper surface of the second phase retardation layer 240 to be in further contact with the upper surface of the second phase retardation layer 240.

The light blocking member 400 may include a resin and a photoinitiator. The resin may include at least one of, for example, an acrylic resin, a urethane resin, an epoxy resin, or a silicone resin. The photoinitiator may initiate a chemical reaction of the resin to enable curing of the resin. The photoinitiator may be an ultraviolet (UV) photoinitiator. In addition, the light blocking member 400 may include a colorant (e.g., a dye or a pigment) for blocking or absorbing light. For example, the light blocking member 400 may include a black colorant.

According to some embodiments, the light blocking member 400 may include a first region 410, a second region 420, and a third region 430. The light blocking member 400 may be applied to the side surface of the display device 10 and then cured through UV curing, as described below. The light blocking member 400 may be divided into the first region 410, the second region 420, and the third region 430 according to a curing rate.

For example, the first region 410 may correspond to an edge (e.g., an outer peripheral surface) region of the light blocking member 400. The first region 410 may cover the second region 420 and the third region 430, and may be located at an outer side of the light blocking member 400. The first region 410 may have a high curing rate because UV light reaches the first region 410 first. For example, the curing rate of the first region 410 may be in a range of 85% to 100%. The first region 410 may be in contact with the display panel 100 and the cover window 20 to increase bonding force between the display panel 100 and the cover window 20. For example, the first region 410 may be in contact with the upper surface of the display panel 100 and the lower surface of the cover window 20.

The second region 420 may correspond to a central portion of the light blocking member 400. For example, the second region 420 may be located between the first region 410 and the third region 430. The second region 420 is a region irradiated with a relatively smaller amount of UV light than the first region 410, and may have a lower curing rate than the first region 410. For example, the curing rate of the second region 420 may be higher than 55% and lower than 85%. The second region 420 may be in contact with the upper surface of the display panel 100 and may not be in contact with the lower surface of the cover window 20.

The third region 430 may correspond to a deep portion (e.g., an inner side portion) of the light blocking member 400, and may be located at an inner side of the light blocking member 400. The third region 430 is a region irradiated with a relatively smaller amount of UV light than the first region 410 and the second region 420, and may have a lower curing rate than the first region 410 and the second region 420. For example, the curing rate of the third region 430 may be in a range of 25% to 55%. The third region 430 may be in contact with the upper surface of the display panel 100 and may not be in contact with the lower surface of the cover window 20.

FIG. 7 illustrates a curing rate of the light blocking member 400 according to a depth measured from a surface of the light blocking member 400 to the inner side of the light blocking member 400. The curing rate illustrated in FIG. 7 is measured through Fourier transform infrared spectroscopy (FT-IR) analysis of the light blocking member.

Referring to FIG. 7, the light blocking member 400 has a curing rate that decreases from the surface (e.g., the outer side) of the light blocking member 400 toward the deep portion (e.g., the inner side) of the light blocking member 400. Here, the depth of the light blocking member 400 is measured from the surface of the light blocking member 400 to the inner side of the light blocking member 400, and may be a depth directed toward the inner side at an angle of 45° with respect to a surface of the cover window 20.

For example, a curing rate of the first region 410 of the light blocking member 400 gradually decreases from the outer side of the light blocking member 400 toward the inner side of the light blocking member 400, a curing rate decrease gradient a of the first region 410 according to the depth is relatively gentle, and the first region 410 shows a curing rate in a range of 85% to 100%. A curing rate of the second region 420 of the light blocking member 400 gradually decreases from the outer side of the light blocking member 400 toward the inner side of the light blocking member 400, a curing rate decrease gradient b of the second region 420 according to the depth is greater than the curing rate decrease gradient a of the first region 410, and the second region 420 shows a curing rate higher than 55% and lower than 85%. A curing rate of the third region 430 of the light blocking member 400 gradually decreases from the outer side of the light blocking member 400 toward the inner side of the light blocking member 400, a curing rate decrease gradient c of the third region 430 according to the depth is smaller than the curing rate decrease gradient b of the second region 420 and greater than the curing rate decrease gradient a of the first region 410, and the third region 430 shows a curing rate in a range of 25% to 55%.

It may be confirmed through FIG. 7 that as the depth of the light blocking member 400 increases, the curing rate gradually decreases and the first region 410, the second region 420, and the third region 430 are divided according to the curing rate of the light blocking member 400. The light blocking member 400 may have a modulus changed depending on the curing rate due to characteristics of the resin. That is, moduli of the first region 410, the second region 420, and the third region 430 of the light blocking member 400 may be different from each other. For example, a modulus of the first region 410 may be greater than moduli of the second region 420 and the third region 430, and a modulus of the second region 420 may be greater than a modulus of the third region 430. That is, the modulus of the third region 430 may be smaller than the moduli of the first region 410 and the second region 420. In embodiments of the present invention, the term "modulus" may refer to Young's modulus.

The third region 430 corresponding to the deep portion of the light blocking member 400 may be in direct contact with the side surface and the upper surface of the second phase retardation layer 240 of the anti-reflection layer 200 as described above. In a case where the anti-reflection layer 200 shrinks in a high-temperature and high-humidity reliability test, when the light blocking member 400 is in a fully cured state, the light blocking member 400 firmly holds the second phase retardation layer 240, such that a crack may occur in the second phase retardation layer 240 when the second phase retardation layer 240 shrinks.

According to some embodiments, by forming the third region 430 of the light blocking member 400 so as to have the curing rate in a range of 25% to 55% to make the modulus of the third region 430 small, it may be possible to prevent or reduce instances of cracks occurring in the second phase retardation layer 240 when the second phase retardation layer 240 shrinks.

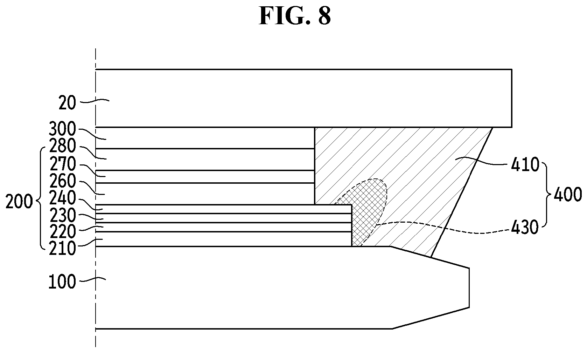

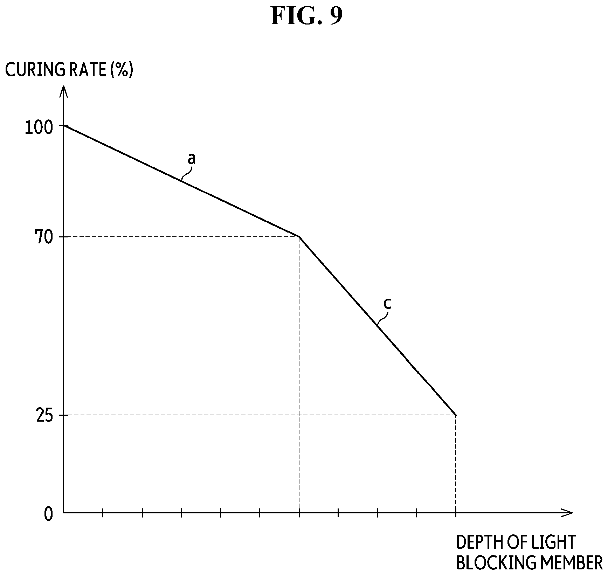

FIG. 8 is a schematic cross-sectional view illustrating a portion of a display device according to some embodiments. FIG. 9 is a graph illustrating a curing rate of a light blocking member. For example, FIG. 8 illustrates another example corresponding to region A of FIG. 5, and FIG. 9 illustrates a curing rate of the light blocking member according to a depth of the light blocking member.

Referring to FIGS. 8 and 9, the present embodiments are different from the embodiments described above with reference to FIGS. 5 to 7 in that the light blocking member 400 includes the first region 410 and the third region 430 and the second region is omitted. Hereinafter, some description of contents or characteristics overlapping those of the above-described embodiments may be omitted, and contents different from those of the above-described embodiments will be described.

The light blocking member 400 may include the first region 410 and the third region 430. The light blocking member 400 may be applied to the side surface of the display device 10 and then cured through UV curing, as described below. The light blocking member 400 may be divided into the first region 410 and the third region 430 according to a curing rate.

For example, the first region 410 occupies most of the light blocking member 400, and may correspond to, for example, the remaining region of the light blocking member 400 excluding a deep portion of the light blocking member 400. The first region 410 may surround the third region 430 while covering the third region 430. The first region 410 may have a high curing rate because UV light reaches the first region 410 first. For example, the curing rate of the first region 410 may be higher than 70% and lower than or equal to 100%. The first region 410 may be in contact with the display panel 100 and the cover window 20 to increase bonding force between the display panel 100 and the cover window 20. In addition, the first region 410 may be in contact with the side surface of the adhesive layer 300 and the side surface of the anti-reflection layer 200.

The third region 430 may correspond to a deep portion (e.g., an inner side portion) of the light blocking member 400. The third region 430 is a region irradiated with a relatively smaller amount of UV light than the first region 410, and may have a lower curing rate than the first region 410. For example, the curing rate of the third region 410 may be in a range of 25% to 70%. The third region 430 may be in contact with the anti-reflection layer 200 and the display panel 100. For example, the third region 430 may be in contact with the side surfaces of the first and second bonding members 210 and 230 and the side surfaces of the first and second phase retardation layers 220 and 240 of the anti-reflection layer 200. In addition, the third region 430 may also be in contact with the upper surface of the second phase retardation layer 240.

FIG. 9 illustrates a curing rate of the light blocking member 400 according to a depth measured from a surface of the light blocking member 400 to the inner side of the light blocking member 400.

Referring to FIG. 9, the light blocking member 400 may have a curing rate that gradually decreases from the surface of the light blocking member 400 toward the inner side of the light blocking member 400. For example, the curing rate of the light blocking member 400 according to the depth measured from the surface of the light blocking member 400 to the inner side of the light blocking member 400 decreases as the depth increases.

For example, a curing rate of the first region 410 of the light blocking member 400 gradually decreases from the outer side of the light blocking member 400 toward the inner side of the light blocking member 400, a curing rate decrease gradient a of the first region 410 according to the depth is relatively gentle, and the first region 410 shows a curing rate higher than 70%. A curing rate of the third region 430 of the light blocking member 400 gradually decreases from the outer side of the light blocking member 400 toward the inner side of the light blocking member 400, a curing rate decrease gradient c of the third region 430 according to the depth is greater than the curing rate decrease gradient a of the first region 410, and the third region 430 shows a curing rate of 25% to 70%.

It may be confirmed through FIG. 9 that as the depth of the light blocking member 400 increases, the curing rate gradually decreases and the first region 410 and the third region 430 are divided according to the curing rate of the light blocking member 400. The light blocking member 400 may have a modulus changed depending on the curing rate due to characteristics of the resin. That is, moduli of the first region 410 and the third region 430 of the light blocking member 400 may be different from each other. For example, a modulus of the first region 410 may be greater than a modulus of the third region 430, and the modulus of the third region 430 may be smaller than the modulus of the first region 410.

Table 1 shows curing rates of light blocking members for each region. In Table 1, three samples of each of light blocking members made of different materials were prepared, applied to and cured on display devices, and then, curing rates of surface regions and deep portion regions were measured by FT-IR analysis. Here, the surface region is an outer surface of the light blocking member, and the deep portion region is a region in contact with the upper surface of the second phase retardation layer 240 in the third regions 430 of FIG. 8.

**Table 1**

| | Sample # | Curing rate (%) of surface region | Curing rate (%) of deep portion region |
|---|---|---|---|
| Light blocking member 1 | 1 | 96.1 | 33.4 |
| | 2 | 96.8 | 35.2 |
| | 3 | 95.9 | 31.7 |
| Light blocking member 2 | 1 | 98.7 | 47.1 |
| | 2 | 97.3 | 55.0 |
| | 3 | 96.5 | 53.2 |

Referring to Table 1, the curing rates of the surface regions of the light blocking members made of the different materials were 95.9% or higher, and the curing rates of the deep portion regions of the light blocking members were 31.7% to 55.0%.

Through this result, it might be confirmed that the curing rate of the first region 410 of the light blocking member 400 according to some embodiments was in the range higher than 70% and lower than or equal to 100% and the curing rate of the third region 430 of the light blocking member 400 was in the range of 25% to 70%.

As described above, according to some embodiments, by forming the third region 430 of the light blocking member 400 to have the curing rate of 25% to 70% to make the modulus of the third region 430 small, it may be possible to prevent or reduce instances of cracks occurring in the second phase retardation layer 240 when the second phase retardation layer 240 shrinks.

Hereinafter, a method of manufacturing the display device according to some embodiments will be described with reference to other drawings.

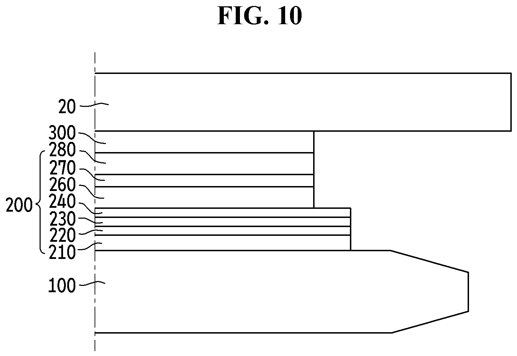

FIGS. 10 to 13 are cross-sectional views illustrating processes of a method of manufacturing the display device according to some embodiments. For example, FIGS. 10 to 13 illustrate display devices of portions corresponding to FIG. 6 described above.

Referring to FIG. 10, the display panel 100 is provided. The display panel 100 may be provided by sequentially forming the circuit driving layer DRL, the light emitting element layer EML, the encapsulation layer ENL, and the touch layer TSL on the substrate SUB, as described above with reference to FIG. 4.

Subsequently, the anti-reflection layer 200 is formed on the display panel 100. The anti-reflection layer 200 may be manufactured through a separate process. For example, the anti-reflection layer 200 may be manufactured by sequentially forming the polarizer layer 270 and the hard coating layer 280 on one surface of the support layer 260 in a mother state, forming the second phase retardation layer 240 on a lower surface of the support layer 260, forming the first bonding member 210 and the second bonding member 230 on both surfaces of the first phase retardation layer 220, respectively, bonding the second bonding member 230 to the second phase retardation layer 240, and then performing cutting in cell units. The manufactured anti-reflection layer 200 may be bonded to one surface of the display panel 100 through the first bonding member 210.

Next, the cover window 20 is formed on the anti-reflection layer 200. The cover window 20 may be bonded to the anti-reflection layer 200 after the adhesive layer 300 are formed on one surface of the cover window 20.

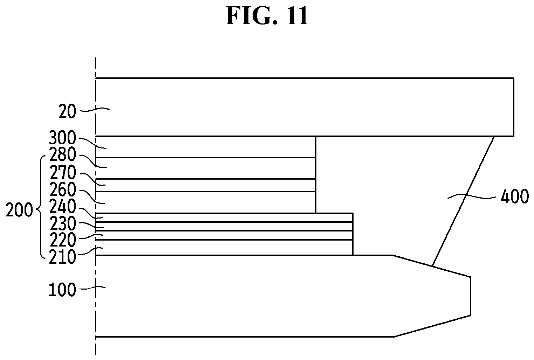

Subsequently, referring to FIG. 11, the light blocking member 400 is formed on a side surface of the display device 10. The light blocking member 400 may be formed by preparing ink including a resin, a photoinitiator, and a colorant and applying the ink to the side surface of the display device 10. The light blocking member 400 may be formed by a solution process such as dispensing, slit coating, inkjet printing, or screen printing. The light blocking member 400 may be applied so as to be in contact with the cover window 20, the display panel 100, the anti-reflection layer 200, and the adhesive layer 300 between the cover window 20 and the display panel 100.

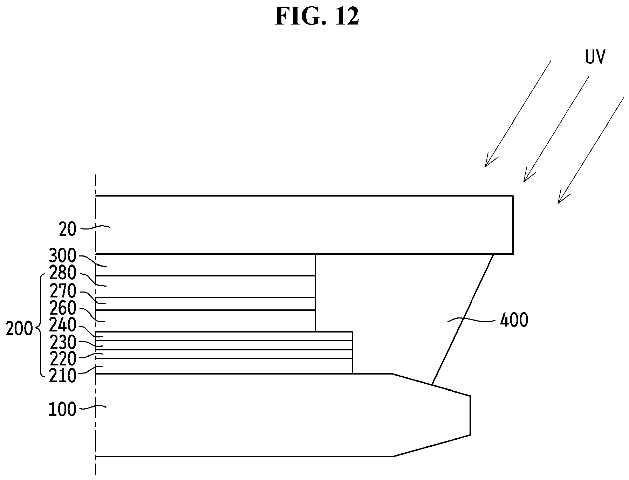

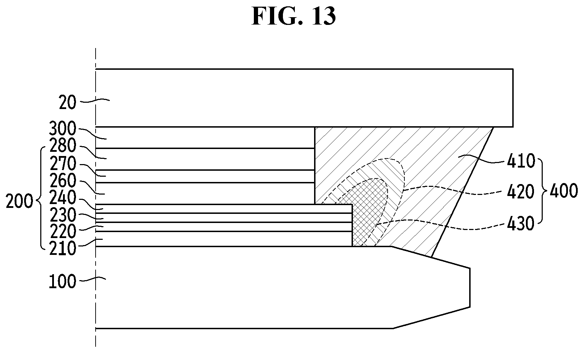

Next, referring to FIGS. 12 and 13, the light blocking member 400 is cured.

For example, UV light is irradiated to the light blocking member 400 at 45° of the right side based on an upper surface of the cover window 20 of the display device 10. When the UV light is irradiated to the light blocking member 400 in a direction of 45°, a curing rate of the light blocking member 400 in portions in contact with the cover window 20 and the display panel 100 may be increased, so that the light blocking member 400 may be well bonded to the cover window 20 and the display panel 100. However, embodiments according to the present disclosure are not limited thereto, and the UV light may also be irradiated to the light blocking member 400 in parallel with the upper surface of the cover window 20 from the side surface of the display device 10.

The UV light may be transmitted through the cover window 20 and be irradiated to the light blocking member 400. A depth at which the UV light may penetrate into the light blocking member 400 may be adjusted depending on an irradiation condition. According to some embodiments, the irradiation condition of the UV light is adjusted so that the deep portion of the light blocking member 400 is uncured. For example, the UV light may be irradiated at power of 300 W to 5000 W for 0.5 seconds to 1 minute.

As illustrated in FIG. 13, when the UV light is irradiated to the light blocking member 400, a curing rate of the light blocking member 400 is high on the surface of the light blocking member 400 and low in the deep portion of the light blocking member 400. For example, the first region 410 having the curing rate of 85% to 100%, the second region 420 having the curing rate higher than 55% and lower than 85%, and the third region 430 having the curing rate of 25% to 55% may be formed according to the curing rate of the light blocking member 400.

According to the method of manufacturing the display device 10 described above, the third region 430 corresponding to the deep portion of the light blocking member 400 may be formed to have the curing rate in the range of 25% to 55%. Accordingly, by making a modulus of a portion of the light blocking member 400 surrounding the second phase retardation layer 240 of the anti-reflection layer 200 small, it may be possible to prevent or reduce instances of cracks occurring in the second phase retardation layer 240 when the second phase retardation layer 240 shrinks.

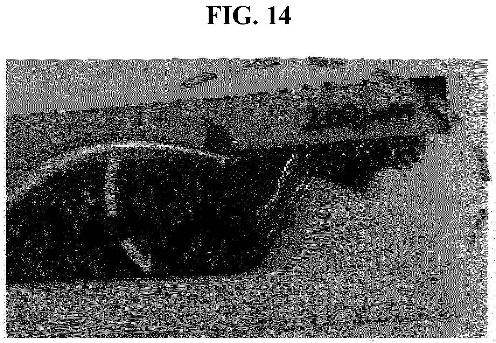

FIG. 14 is an image of an uncured light blocking member. FIG. 14 illustrates an appearance of a torn uncured light blocking member.

Referring to FIG. 14, when the light blocking member 400 is uncured to have a curing rate of 30%, a modulus of the light blocking member 400 is small, such that an appearance of the light blocking member 400 that is easily torn may be confirmed.

Through this, it may be expected that in the present embodiments, by making the modulus of the portion of the light blocking member 400 surrounding the second phase retardation layer 240 of the anti-reflection layer 200 small, it may be possible to prevent or reduce instances of cracks occurring in the second phase retardation layer 240 when the second phase retardation layer 240 shrinks.

In concluding the detailed description, those skilled in the art will appreciate that many variations and modifications can be made to the disclosed embodiments without departing from the scope of embodiments according to the present disclosure. Therefore, the disclosed embodiments of the invention are used in a generic and descriptive sense only and not for purposes of limitation.

## Claims

1. A display device comprising:
a display panel;
an anti-reflection layer on the display panel and including at least one polarizer layer;
a cover window on the anti-reflection layer; and
a light blocking member between the cover window and the display panel and on a side surface of the anti-reflection layer,
wherein the light blocking member includes a first region and a second region having different curing rates, and
at least one of the first region or the second region is in contact with the anti-reflection layer.

2. The display device of claim 1, wherein the first region covers the second region and is at an outer side of the light blocking member, and the second region is at an inner side of the light blocking member.

3. The display device of claim 1 or claim 2, wherein the first region contacts each of a lower surface of the cover window and an upper surface of the display panel, and the second region does not contact the lower surface of the cover window.

4. The display device of any one of claims 1 to 3, wherein a curing rate of the first region is higher than that of the second region.

5. The display device of any one of claims 1 to 4, wherein a curing rate of the first region is in a range of 85% to 100%.

6. The display device of any one of claims 1 to 5, wherein a curing rate of the second region is in a range of 25% to 55%.

7. The display device of any one of claims 1 to 6, wherein the light blocking member further includes a third region between the first region and the second region, and
a curing rate of the third region is lower than a curing rate of the first region and higher than a curing rate of the second region, optionally wherein a curing rate of the third region is higher than 55% and lower than 85%.

8. The display device of any one of claims 1 to 7, wherein the anti-reflection layer includes:
a first bonding member on the display panel;
a first phase retardation layer on the first bonding member;
a second bonding member on the first phase retardation layer;
a second phase retardation layer on the second bonding member;
a support layer on the second phase retardation layer; and
a hard coating layer on the polarizer layer, and
the polarizer layer is between the support layer and the hard coating layer, optionally wherein the second region contacts an upper surface and a side surface of the second phase retardation layer.

9. A display device according to claim 1, wherein the anti-reflection layer further includes phase retardation layers;
the second region has a curing rate lower than a curing rate of the first region; and
the second region is in contact with any one of the phase retardation layers.

10. The display device of claim 9, wherein the first region covers the second region and is at an outer side of the light blocking member, and the second region is at an inner side of the light blocking member.

11. The display device of claim 9 or claim 10, wherein:
(i) the curing rate of the first region is higher than 70% and lower than or equal to 100%; and/or
(ii) the curing rate of the second region is in a range of 25% to 70%.

12. The display device of any one of claims 9 to 11, wherein a modulus of the second region is smaller than a modulus of the first region.

13. An electronic device comprising the display device of claim 1.

14. The electronic device of claim 13, wherein the curing rate of each of the first region and the second region decreases from an outer side of the light blocking member toward an inner side of the light blocking member, optionally wherein a curing rate decrease gradient of the second region is greater than a curing rate decrease gradient of the first region.

15. The electronic device of claim 13 or claim 14, wherein the light blocking member further includes a third region between the first region and the second region, and
a curing rate of the third region decreases from the outer side of the light blocking member toward the inner side of the light blocking member, optionally wherein a curing rate decrease gradient of the third region is greater than the curing rate decrease gradient of the first region and the curing rate decrease gradient of the second region.

## Patentansprüche

1. Anzeigevorrichtung, umfassend:
ein Anzeigefeld;
eine Antireflexionsschicht auf dem Anzeigefeld, die mindestens eine Polarisationsschicht einschließt;
ein Abdeckfenster auf der Antireflexionsschicht; und
ein lichtundurchlässiges Element zwischen dem Abdeckfenster und dem Anzeigefeld sowie auf einer Seitenfläche der Antireflexionsschicht,
wobei das lichtundurchlässige Element einen ersten Bereich und einen zweiten Bereich mit unterschiedlichen Aushärtungsraten einschließt, und
mindestens einer von dem ersten Bereich oder dem zweiten Bereich in Kontakt mit der Antireflexionsschicht steht.

2. Anzeigevorrichtung nach Anspruch 1, wobei der erste Bereich den zweiten Bereich bedeckt und sich auf einer Außenseite des lichtundurchlässigen Elements befindet, und der zweite Bereich sich auf einer Innenseite des lichtundurchlässigen Elements befindet.

3. Anzeigevorrichtung nach Anspruch 1 oder Anspruch 2, wobei der erste Bereich sowohl die untere Oberfläche des Abdeckfensters als auch die obere Oberfläche des Anzeigefelds berührt und der zweite Bereich die untere Oberfläche des Abdeckfensters nicht berührt.

4. Anzeigevorrichtung nach einem der Ansprüche 1 bis 3, wobei die Aushärtungsrate des ersten Bereichs höher ist als die des zweiten Bereichs.

5. Anzeigevorrichtung nach einem der Ansprüche 1 bis 4, wobei die Aushärtungsrate des ersten Bereichs in einem Bereich von 85 % bis 100 % liegt.

6. Anzeigevorrichtung nach einem der Ansprüche 1 bis 5, wobei die Aushärtungsrate des zweiten Bereichs in einem Bereich von 25 % bis 55 % liegt.

7. Anzeigevorrichtung nach einem der Ansprüche 1 bis 6, wobei das lichtundurchlässige Element ferner einen dritten Bereich zwischen dem ersten Bereich und dem zweiten Bereich einschließt, und
die Aushärtungsrate des dritten Bereichs niedriger als die des ersten Bereichs ist und höher als die des zweiten Bereichs ist, wobei die Aushärtungsrate des dritten Bereichs optional höher als 55 % und niedriger als 85 % ist.

8. Anzeigevorrichtung nach einem der Ansprüche 1 bis 7, wobei die Antireflexionsschicht einschließt:
ein erstes Verbindungselement auf dem Anzeigefeld;
eine erste Phasenverzögerungsschicht auf dem ersten Verbindungselement;
ein zweites Verbindungselement auf der ersten Phasenverzögerungsschicht;
eine zweite Phasenverzögerungsschicht auf dem zweiten Verbindungselement;
eine Trägerschicht auf der zweiten Phasenverzögerungsschicht; und
eine Hartbeschichtungsschicht auf der Polarisatorschicht, und
die Polarisatorschicht befindet sich zwischen der Trägerschicht und der Hartbeschichtungsschicht, wobei der zweite Bereich optional eine obere Oberfläche und eine Seitenfläche der zweiten Phasenverzögerungsschicht berührt.

9. Anzeigevorrichtung nach Anspruch 1, wobei die Antireflexionsschicht ferner Phasenverzögerungsschichten einschließt;
der zweite Bereich eine Aushärtungsrate aufweist, die niedriger ist als eine Aushärtungsrate des ersten Bereichs; und
der zweite Bereich in Kontakt mit einer der Phasenverzögerungsschichten steht.

10. Anzeigevorrichtung nach Anspruch 9, wobei der erste Bereich den zweiten Bereich bedeckt und sich auf einer Außenseite des lichtundurchlässigen Elements befindet, und der zweite Bereich sich auf einer Innenseite des lichtundurchlässigen Elements befindet.

11. Anzeigevorrichtung nach Anspruch 9 oder Anspruch 10, wobei
(i) die Aushärtungsrate des ersten Bereichs höher als 70 % ist und niedriger oder gleich 100 % ist; und/oder
(ii) die Aushärtungsrate des zweiten Bereichs in einem Bereich von 25 % bis 70 % liegt.

12. Anzeigevorrichtung nach einem der Ansprüche 9 bis 11, wobei ein Modul des zweiten Bereichs kleiner ist als ein Modul des ersten Bereichs.

13. Elektronische Vorrichtung, umfassend die Anzeigevorrichtung nach Anspruch 1.

14. Elektronische Vorrichtung nach Anspruch 13, wobei die Aushärtungsrate sowohl des ersten als auch des zweiten Bereichs von einer Außenseite des lichtundurchlässigen Elements zu einer Innenseite des lichtundurchlässigen Elements hin abnimmt, wobei ein Gradient der Abnahme der Aushärtungsrate des zweiten Bereichs optional größer ist als ein Gradient der Abnahme der Aushärtungsrate des ersten Bereichs.

15. Elektronische Vorrichtung nach Anspruch 13 oder Anspruch 14, wobei das lichtundurchlässige Element ferner einen dritten Bereich zwischen dem ersten Bereich und dem zweiten Bereich einschließt, und
eine Aushärtungsrate des dritten Bereichs von der Außenseite des lichtundurchlässigen Elements zu der Innenseite des lichtundurchlässigen Elements hin abnimmt, wobei ein Gradient der Abnahme der Aushärtungsrate des dritten Bereichs optional größer ist als der Gradient der Abnahme der Aushärtungsrate des ersten Bereichs und der Gradient der Abnahme der Aushärtungsrate des zweiten Bereichs.

## Revendications

1. Dispositif d'affichage comprenant :
un panneau d'affichage ;
une couche antireflet sur le panneau d'affichage et incluant au moins une couche polarisante ;
une fenêtre de protection sur la couche antireflet ; et
un élément bloquant la lumière entre la fenêtre de protection et le panneau d'affichage et sur une surface latérale de la couche antireflet,
dans lequel l'élément bloquant la lumière inclut une première région et une deuxième région présentant des vitesses de durcissement différentes, et
au moins l'une de la première région ou de la deuxième région est en contact avec la couche antireflet.

2. Dispositif d'affichage selon la revendication 1, dans lequel la première région recouvre la deuxième région et se trouve d'un côté extérieur de l'élément bloquant la lumière, et la deuxième région se trouve d'un côté intérieur de l'élément bloquant la lumière.

3. Dispositif d'affichage selon la revendication 1 ou la revendication 2, dans lequel la première région est en contact avec la surface inférieure de la fenêtre de protection et la surface supérieure du panneau d'affichage, et la deuxième région n'est pas en contact avec la surface inférieure de la fenêtre de protection.

4. Dispositif d'affichage selon l'une quelconque des revendications 1 à 3, dans lequel un taux de durcissement de la première région est supérieur à celui de la deuxième région.

5. Dispositif d'affichage selon l'une quelconque des revendications 1 à 4, dans lequel un taux de durcissement de la première région est compris dans une plage de 85 % à 100 %.

6. Dispositif d'affichage selon l'une quelconque des revendications 1 à 5, dans lequel un taux de durcissement de la deuxième région est compris dans une plage de 25 % à 55 %.

7. Dispositif d'affichage selon l'une quelconque des revendications 1 à 6, dans lequel l'élément bloquant la lumière inclut en outre une troisième région entre la première région et la deuxième région, et
un taux de durcissement de la troisième région est inférieur à un taux de durcissement de la première région et supérieur à un taux de durcissement de la deuxième région, dans lequel éventuellement un taux de durcissement de la troisième région est supérieur à 55 % et inférieur à 85 %.

8. Dispositif d'affichage selon l'une quelconque des revendications 1 à 7, dans lequel la couche antireflet inclut :
un premier élément de liaison sur le panneau d'affichage ;
une première couche de retardement de phase sur le premier élément de liaison ;
un second élément de liaison sur la première couche de retardement de phase ;
une seconde couche de retardement de phase sur le second élément de liaison ;
une couche de support sur la seconde couche de retardement de phase ; et
une couche de revêtement dur sur la couche polarisante, et
la couche polarisante se trouve entre la couche de support et la couche de revêtement dur, éventuellement dans lequel la deuxième région est en contact avec une surface supérieure et une surface latérale de la seconde couche de retardement de phase.

9. Dispositif d'affichage selon la revendication 1, dans lequel la couche antireflet inclut en outre des couches de retardement de phase ;
la deuxième région présente un taux de durcissement inférieur à un taux de durcissement de la première région ; et
la deuxième région est en contact avec l'une quelconque des couches de retardement de phase.

10. Dispositif d'affichage selon la revendication 9, dans lequel la première région recouvre la deuxième région et se trouve d'un côté extérieur de l'élément bloquant la lumière, et la deuxième région se trouve d'un côté intérieur de l'élément bloquant la lumière.

11. Dispositif d'affichage selon la revendication 9 ou la revendication 10, dans lequel :
(i) le taux de durcissement de la première région est supérieur à 70 % et inférieur ou égal à 100 % ; et/ou
(ii) le taux de durcissement de la deuxième région est compris dans la plage de 25 % à 70 %.

12. Dispositif d'affichage selon l'une quelconque des revendications 9 à 11, dans lequel un module de la deuxième région est inférieur à un module de la première région.

13. Dispositif électronique, comprenant le dispositif d'affichage selon la revendication 1.

14. Dispositif électronique selon la revendication 13, dans lequel le taux de durcissement de chacune de la première région et de la deuxième région diminue d'un côté extérieur de l'élément bloquant la lumière vers un côté intérieur de l'élément bloquant la lumière, éventuellement dans lequel un gradient de diminution de taux de durcissement de la deuxième région est supérieur à un gradient de diminution de taux de durcissement de la première région.

15. Dispositif électronique selon la revendication 13 ou la revendication 14, dans lequel l'élément bloquant la lumière inclut en outre une troisième région entre la première région et la deuxième région, et
un taux de durcissement de la troisième région diminue du côté extérieur de l'élément bloquant la lumière vers le côté intérieur de l'élément bloquant la lumière, éventuellement dans lequel un gradient de diminution de taux de durcissement de la troisième région est supérieur au gradient de diminution de taux de durcissement de la première région et au gradient de diminution de taux de durcissement de la deuxième région.
